# EUROPÄISCHE PATENTSCHRIFT

(11) **EP 3 017 078 B1**
(45) Veröffentlichungstag und Bekanntmachung des Hinweises auf die Patenterteilung: **16.12.2020**
(21) Anmeldenummer: 14735472.4
(22) Anmeldetag: 30.06.2014
(51) Int. Cl.: C23C 14/06, C23C 14/34, H01J 37/34

(54) **TIB2-SCHICHTEN UND IHRE HERSTELLUNG**
TIB2 LAYERS AND THEIR PREPARATION
COUCHES DE TIB2 ET LEUR PRÉPARATION

(30) Priorität: 03.07.2013 DE 102013011075
(43) Veröffentlichungstag der Anmeldung: 11.05.2016
(73) Patentinhaber: Oerlikon Surface Solutions AG, Pfäffikon, 8808 Pfäffikon, SZ (CH)
(72) Erfinder: KURAPOV, Denis, CH-8880 Walenstadt (CH); KRASSNITZER, Siegfried, A-6800 Feldkirch (AT)
(74) Vertreter: Misselhorn, Hein-Martin
(86) Internationale Anmeldenummer: PCT/EP2014/001781
(87) Internationale Veröffentlichungsnummer: WO 2015/000576

(56) Entgegenhaltungen:
- MIKULA M ET AL: "Mechanical properties of superhard TiB2 coatings prepared by DC magnetron sputtering", VACUUM, Bd. 82, Nr. 2, 17. August 2007 (2007-08-17), Seiten 278-281, XP022299625, Pergamon Press [GB] ISSN: 0042-207X, DOI: 10.1016/J.VACUUM.2007.07.036
- F KUNC ET AL: "Low-stress superhard Ti-B films prepared by magnetron sputtering", SURFACE AND COATINGS TECHNOLOGY, Bd. 174-175, 26. April 2003 (2003-04-26), Seiten 744-753, XP055137177, Elsevier [CH] ISSN: 0257-8972, DOI: 10.1016/S0257-8972Z03.00425-0
- KONCA E ET AL: "Transfer of 319 Al alloy to titanium diboride and titanium nitride based (TiAlN, TiCN, TiN) coatings: effects of sliding speed, temperature and environment", SURFACE AND COATINGS TECHNOLOGY, Bd. 200, Nr. 7, 26. November 2004 (2004-11-26), Seiten 2260-2270, XP027608593, Elsevier, Amsterdam [NL] ISSN: 0257-8972, DOI: 10.1016/j.surfcoat.2004.10.008 [gefunden am 2005-12-21]
- WIEDEMANN R ET AL: "Structure of deposited and annealed TiB2 layers", SURFACE AND COATINGS TECHNOLOGY, Bd. 97, Nr. 1-3, Dezember 1997 (1997-12), Seiten 313-321, XP027367661, Elsevier, Amsterdam [NL] ISSN: 0257-8972, DOI: 10.1016/S0257-8972(97)00204-1 [gefunden am 1997-12-01]
- KNOTEK O ET AL: "Magnetron-sputtered superhard coatings within the system Ti-B-C-N", VACUUM, vol. 41, no. 7-9, 1990, pages 2184-2186, XP025752004, PERGAMON PRESS [GB] ISSN: 0042-207X, DOI: 10.1016/0042-207X(90)94220-K [retrieved on 1990-01-01]

## Beschreibung

Die vorliegende Erfindung bezieht sich auf ein Verfahren zur Herstellung einer Beschichtung, welche mindestens eine TiB₂ Schicht umfasst.

Es ist bekannt, TiB₂ als Schichtmaterial für Werkzeuge einzusetzen. Beispielsweise wird in US 4820392 sowie in "Magnetron-sputtered superhard coatings within the system Ti-B-C-N", Knotek et al., Vacuum / volume 41 / numbers 7-9 / pages 2184 to 2186 / 1990 beschrieben, wie mittels eines Zerstäubungsverfahrens (sputtering) eine TiB₂ Schicht auf Werkzeuge aufgebracht wird. Obwohl sich das so aufgebrachte Material durch gute mechanische und tribologische Eigenschaften auszeichnet, wird in der Praxis eine höhere Dichte und noch größere Härte angestrebt.

Da es sich bei TiB₂ um ein Material mit sehr hohem Schmelzpunkt handelt, kann das sogenannte Lichtbogenverdampfen, welches zu dichteren und damit härteren Schichten führen würde, nicht wirtschaftlich eingesetzt werden.

Eine bekannte Möglichkeit, die Dichte und Härte von Sputterschichten in dem Funkenverdampfen ähnliche Bereiche zu schieben, ist das sogenannte HiPIMS Verfahren. (HiPIMS = High Power Impulse Magnetron Sputtering). Bei diesem Sputterverfahren wird eine Sputterkathode mit hohen Leistungspulsdichten beaufschlagt, was dazu führt, dass das von der Kathode zerstäubte Material zu einem hohen Prozentsatz ionisiert ist. Wird nun eine negative Spannung an die zu beschichtenden Werkstücke angelegt, so werden diese Ionen in Richtung Werkstücke beschleunigt, was zu sehr dichten Schichten führt.

Die Sputterkathode muss pulsweise mit Leistung beaufschlagt werden, um ihr Zeit zu geben, den mit der Leistung einhergehenden Wärmeeintrag abzuführen. Beim HiPIMS Verfahren wird als Leistungsquelle daher ein Pulsgenerator benötigt. Dieser Pulsgenerator muss in der Lage sein, sehr hohe Leistungspulse abzugeben, die jedoch sehr kurz sind. Die heute erhältlichen Pulsgeneratoren zeigen wenig Flexibilität, was zum Beispiel Pulshöhe und/oder Pulsdauer betrifft. Idealerweise sollte ein Rechteckpuls abgegeben werden. Zumeist ist jedoch die Leistungsabgabe innerhalb eines Pulses stark zeitabhängig, was unmittelbar Einfluss auf die Schichteigenschaften, wie zum Beispiel Härte, Haftung, Eigenspannung etc. hat. Außerdem wird die Beschichtungsrate durch die Abweichung vom Rechteckprofil negativ beeinflusst.

Insbesondere werfen diese Schwierigkeiten Fragen hinsichtlich der Reproduzierbarkeit auf.

Die Dokumente "Mechanical properties of superhard TiB2 coatings prepared by DC magentron sputtering", Mikula et al., Vacuum 82 (2008) 278-281 und "Low-stress superhard Ti-B films prepared by magnetron sputtering", Kunc. et al., Surface and Coatings Technology 174-175 (2003) 744-753 beschreiben Magnetron-Sputter Verfahren, wie sie allgemein aus dem Stand der Technik bekannt sind. Aus den oben dargelegten Gründen können bei den in diesen beiden Dokumenten beschriebenen Verfahren jedoch nicht präzise genug die gewünschten Schichteigenschaften, wie zum Beispiel Härte, Haftung, Eigenspannung etc. hergestellt werden.

Es besteht daher ein Bedürfnis nach einem Verfahren, demgemäss TiB₂ Schichten mittels Magnetronzerstäuben bei hoher Leistung hergestellt werden können. Erfindungsgemäß werden die Schichten mittels eines Sputterverfahrens hergestellt bei dem es zur konstant hohen Leistungsabgabe der Leistungsquelle kommt. Dabei kommen mehrere Sputterkathoden zum Einsatz. Anders als bei den konventionellen HiPIMS Verfahren wird kein Pulsgenerator eingesetzt sondern es wird zunächst lediglich eine erste Sputterkathode mit der vollen Leistung der Leistungsquelle und damit mit hoher Leistungsdichte beaufschlagt. Anschließend wird eine zweite Sputterkathode mit den Ausgängen der Leistungsquelle verbunden. Dabei passiert zunächst wenig da die Impedanz der zweiten Sputterkathode zu diesem Zeitpunkt weitaus höher ist als die Impedanz der ersten Sputterkathode. Erst wenn die erste Sputterkathode von den Ausgängen der Leistungsquelle getrennt wird erfolgt die Leistungsabgabe im Wesentlichen über die zweite Sputterkathode. Das entsprechende Hochleistungsmagnetron-Sputterverfahren ist genauer in der WO 2013060415 beschrieben. Typscherweise wird die Leistungsquelle dabei in der Grössenordnung von 60kW gefahren. Typische Leistungen, welchen die Sputterkathoden im zeitlichen Mittel ausgesetzt sind, liegen grössenordnungsmässig bei 8kW.

Die Erfinder haben nun herausgefunden, dass wenn ein solches Verfahren mit keramischen Targets, z.B. mit TiB₂-Targets als Sputterkathoden betrieben werden, es gelingt, reproduzierbar Schichten mit sehr guten mechanischen Eigenschaften zu erzeugen. Des Weiteren haben die Erfinder herausgefunden, dass bei einem solchen nichtreaktiven Prozess mittels Einstellen des Partialdrucks des Arbeitsgases die Schichtrauigkeit unmittelbar beeinflusst werden kann und zwar ohne dass dies signifikant negativen Einfluss auf die oben genannten mechanischen Eigenschaften hat. Das erfindungsgemäße Verfahren ist in Anspruch 1 definiert. Eine bevorzugte Ausführungsform des Verfahrens ist in Anspruch 2 definiert.

Im Beispiel wurden TiB₂-Schichten hergestellt. Diese Schichten weisen eine Textur auf, im XRD - Spektrum zu deutlichen Peaks führen, welche eine ausgeprägte (001)- Ausrichtung anzeigen. Eine solche Ausrichtung erweist sich als sehr vorteilhaft bei vielen Anwendungen, in welchen Hartstoffschichten benötigt werden.

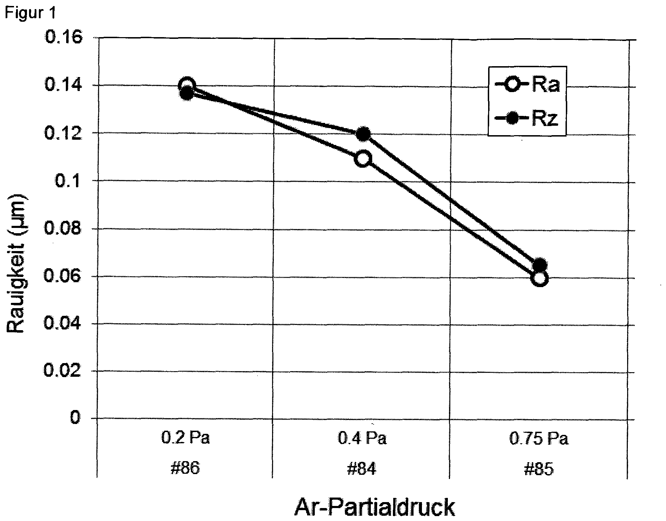

Um den Einfluss des Partialdruckes des Arbeitsgases auf die Rauigkeit nachzuweisen, wurde mit unterschiedlichen Argongasflüssen gearbeitet. So wurde bei einem Argongasfluss von 80sccm Rauheitswerte von Ra = 0.14µm und Rz von 0.115 µm gemessen, bei einem Argongasfluss von 160sccm Rauheitswerte von Ra = 0.115µm und Rz von 0.095 µm gemessen und bei einem Argongasfluss von 300sccm Rauheitswerte von Ra = 0.06µm und Rz von 0.05 µm gemessen. In der Beschichtungsanlage, die zum Einsatz kam, entsprach ein Argonfluss von 80sccm einem Partialdruck von 0.2 Pa, ein Argonfluss von 160sccm einem Partialdruck von 0.4 Pa und ein Argonfluss von 300sccm einem Partialdruck von 0.75 Pa. Dies ist in Figur 1 dargestellt.

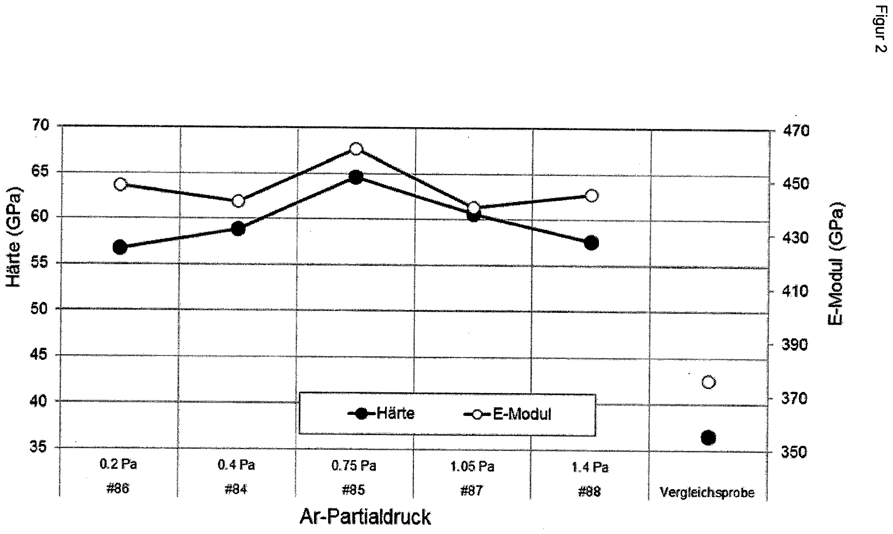

Demgegenüber blieben die Härte der Schichten und das E-Modul der Schichten konstant gut. Dies ist in Figur 2 dargestellt.

Mit der vorliegenden Erfindung wurde also ein Verfahren offenbart zur effizienten und wirtschaftlichen Herstellung von TiB₂ Schichten. Dieses Verfahren führt zu TiB₂ Schichten mit bisher nicht bekannter Härte kombiniert mit sehr niedrigen Rauigkeitswerten. Dies ist vor allem im Zusammenhang mit Anwendungen auf gleitenden Oberflächen sehr interessant. Die bisherigen konventionellen PVD-Zerstäubungsverfahren erlaubten nicht die Herstellung solch harter TiB₂ Schichten.

## Patentansprüche

1. Verfahren zur Beschichtung eines Werkstücks mit einer TiB₂ umfassenden Schicht mit folgenden Schritten:
- Bestücken einer Beschichtungskammer mit dem zu beschichtenden Werkstück
- Abscheiden der TiB₂ umfassenden Schicht mittels eines nichtreaktiven Hochleistungsmagnetron-Sputterverfahrens in einer Arbeitsgas-enthaltenden Atmosphäre durch wechselweises Beaufschlagen von TiB₂ Targets, **dadurch gekennzeichnet, dass** zumindest zwei TiB₂ Targets mit der Leistung einer DC Leistungsquelle von grösser 20 kW beaufschlagt werden, dergestalt dass zeitweise die Leistungsdichte auf den Targets zu einer Stromdichte von lokal grösser 0.2 A/cm² führt, wobei die Targets im zeitlichen Mittel eine Leistung von nicht mehr als 10 kW verarbeiten müssen, dass die Rauigkeit der TiB₂ umfassenden Schicht mittels Einstellens des Partialdrucks des Arbeitsgases beeinflusst wird, und dass zum Sputtern ein Arbeitsgaspartialdruck von nicht weniger als 0.75 Pa zumindest zeitweise aufrecht erhalten wird.

2. Verfahren nach Anspruch 1, **dadurch gekennzeichnet, dass** das Arbeitsgas zumindest Argon enthält.

## Claims

1. A method for coating a work piece having a layer containing TiB₂ with the following steps:
- equipping a coating chamber with the workpiece to be coated
- depositing the layer containing TiB₂ using a nonreactive high power magnetron sputtering process in an atmosphere containing a working gas by alternately acting on TiB₂ targets, **characterized in that** at least two TiB₂ targets are acted on with a power of greater than 20 kW from a DC power source, such that the power density temporarily results in a local current density of more than 0,2 A/cm² on the targets, wherein the targets have to process a power of no greater than 10 kW, averaged over time, that the roughness of the layer containing TiB₂ is influenced by setting the partial pressure of the working gas, and that a partial pressure of the working gas of not less than 0,75 Pa is maintained at least temporarily for sputtering.

2. The method according to claim 1, **characterized in that** the working gas contains at least argon.

## Revendications

1. Procédé de revêtement d'une pièce ayant une couche comprenant TiB₂ avec les étapes suivantes:
- équiper une chambre de revêtement de la pièce à revêtir
- déposer la couche comprenant TiB₂ au moyen d'un procédé non-réactif de pulvérisation magnétron à haute puissance dans une atmosphère contenant du gaz de travail en agissant en alternance sur des cibles TiB₂, **caractérisé en ce qu'**au moins deux cibles TiB₂ sont soumises à la puissance d'une source de courant continu supérieure à 20 kW de telle manière que la densité de puissance sur les cibles conduit à une densité de courant qui est localement supérieure à 0,2 A/cm², les cibles devant traiter une puissance ne dépassant pas 10 kW en moyenne, que la rugosité de la couche comprenant TiB₂ est influencée par le réglage de la pression partielle du gaz de travail, et une pression partielle du gaz de travail d'au moins 0,75 Pa est maintenue au moins temporairement pour la pulvérisation.

2. Procédé selon la revendication 1, **caractérisé en ce que** le gaz de travail contient au moins de l'argon.
